# EUROPEAN PATENT APPLICATION

(11) **EP 0 536 730 A1**
(43) Date of publication of application: **14.04.1993**
(21) Application number: 92117136.9
(22) Date of filing: 07.10.1992
(51) Int. Cl.: C04B 35/00, H01L 39/24

(54) **Oxide superconducting material and method for producing the same**

(30) Priority: 08.10.1991 JP 260146/91
(71) Applicant: INTERNATIONAL SUPERCONDUCTIVITY TECHNOLOGY CENTER, Tokyo 105 (JP); THE TOKYO ELECTRIC POWER CO., INC., Chiyoda-ku, Tokyo 100 (JP); NISSAN MOTOR CO., LTD., Yokohama-shi Kanagawa-ken (JP); MITSUBISHI DENKI KABUSHIKI KAISHA, Chiyoda-ku Tokyo (JP)
(72) Inventor: Wakata, Mitsunobu, c/o Superconductivity Res. Lab., Koto-ku, Tokyo 135 (JP); Takano, Satoshi, c/o Superconductivity Res. Lab., Koto-ku, Tokyo 135 (JP); Munakata, Fumio, c/o Superconductivity Res. Lab., Koto-ku, Tokyo 135 (JP); Yamauchi, Hisao, c/o Superconductivity Res. Lab., Koto-ku, Tokyo 135 (JP)
(74) Representative: Bühling, Gerhard, Dipl.-Chem.

(57) **Abstract**

According to the present invention, there is provided an oxide superconducting material

Bi₂₋ₓPbₓ(Sr, Ca)₃Cu₂O_{q} (0.2 ≦ x ≦ 0.6, q ≦ 8.2) (1)

having orthorhombic and/or monoclinic structures. The present invention also provides a method for producing the above oxide superconducting material comprising the steps of forming a composition of Bi, Pb, Sr, Ca and Cu mixed at an atomic ratio of Bi : Pb : Sr : Ca : Cu = 2-x : x : 2 : 1 : 2, and thermally treating the composition in an inert gas atmosphere with oxygen partial pressure of 1/13 atm or less.

The oxide superconducting material of the present invention is applicable at a higher temperature and at a higher magnetic field.

## Description

### BACKGROUND OF THE INVENTION

### Field of the Invention

The present invention relates to an oxide superconducting material of Bi₂(Sr, Ca)₃Cu₂O_{q} which is used in a higher magnetic field primarily including for superconducting magnets and a method for producing the same.

### Prior Art

Due to not only the higher critical temperature (Tc) but also the critical magnetic field (Bc₂) and critical current density (Jc) both essentially high enough, oxide superconducting materials have been expected of their application to the wire materials for superconducting magnets, power lead and the like. For such utilities, a higher Jc is demanded at a higher magnetic field for long-size and large-area superconducting materials in their entirety.

However, polycrystalline oxide superconducting materials have problems in that the Jc which can flow in its entire sample is low and the dependency thereof on magnetic field and temperature is great (Jc rapidly decreases as magnetic field and temperature get higher). This is because (1) the Jc which can pass through the crystalline particles in the entire sample (Jc^{inter}) is far lower than the Jc which can flow within the crystalline particles (Jc^{intra}) (weak bonding) and (2) the pinning strength for a magnetic flux quantized in the samples, via the heterogeneous points (pinning center) inside the crystalline particles is weak (weak pinning strength), which strength determines the Jc in a higher magnetic field.

For YBa₂Cu₃O_{7-q} materials having Tc around 90 K, alternatively, the technique to disperse non-superconducting deposits such as Y₂BaCuO₅ and the like within the crystal particles has been developed through the improvement of melting process, so that the problem of weak pinning strength is greatly improved to achieve a sufficiently high Jc^{intra} at the temperature of liquid nitrogen (77 K) and in a magnetic field of several T(tesla)s. However, the dispersion technique of non-superconducting deposits has an action rather to deteriorate (lower) Jc^{inter} from the respect of the problem of weak bonding. This would be because the non-superconducting particles also deposits at the border of the crystalline particles.

Through the development of the technique to orient the crystalline axis of each crystalline particle in Bi₂(Sr, Ca)₃Cu₂O_{q} oxide superconducting materials, alternatively, the problem of weak bonding has been improved distinctively. That is, there are mainly present in the materials two superconducting phases of Bi₂Sr₂CaCu₂O_{8+q} (2212 (derived from atomic ratios of Bi, Sr, Ca and Cu) phase) of Tc ≃ 80 K and Bi₂Sr₂Ca₂Cu₃O_{10+q} (2223 phase) of Tc ≃ 110 K. Herein, it has been difficult to obtain a single phase (phase without impurities) of the latter, but as is known, the substitution of a part of Bi with Pb enables the easy production of a pure superconducting material of Tc > 105 K.

For these two Bi materials, there has been developed a method for preparing a dense and tape-shaped sintered product with accurate arrangement of the C axis of the crystalline particles in the vertical direction of the surface, via the repetition of uniaxial press and re-sintering thermal treatment, or the semi-melting thermal treatment at the interface of Ag, whereby the problem of weak bonding has distinctively been improved. In 2223 phase, Jc exceeding 10⁸ A/cm² to a 1-T magnetic field in the direction vertical to the C axis is obtained at 77 K.

In Bi 2223 phase, however, the deterioration of Jc is great in a magnetic field exceeding the above intensity, and the anisotropy of Jc to the direction of a magnetic field is high (the deterioration of Jc is great to a magnetic field parallel to C axis). Therefore, the practical application to superconducting magnets is considered difficult at 77 K, because not only the magnetic field vertical to the C axis is applied in actual superconducting magnets.

In case of Bi 2212 phase, alternatively, the property of a higher Jc has been obtained at lower temperatures rather than in 2212 phase. As shown by H. Kumakura, et al. (Appl. Phys. Lett., Vol. 58 (1991), p. 2830), for example, Jc over 10⁹ A/m² has been reported at 4.2 K even in a magnetic field above 20T. Therefore, it has been considered certain that there will be a superconducting magnet capable of generating a magnetic field above 20 T under 4.2 K.

Herein, the atomic ratio of Sr and Ca in 2212 phase is not limited to 2:1, and it has been known that a pure phase can be generated up to 1:1. Thus, the representation as Bi₂(Sr, Ca)₃Cu₂O_{q} is also possible.

Because oxide superconducting materials have higher Tc, the possibility of the application at a higher temperature has been under investigation. If such application is possible under cooling in liquid nitrogen (20 K), not only the cooling cost can be cut but also the reliability of the cooling system is also improved remarkably.

However, tape-shaped materials of Bi 2212 phase having excellent Jc property at 4.2 K exhibit more dependencies from magnetic field and temperature at a temperature higher than 20 K. The anisotropy to the direction of magnetic field also becomes greater under this temperature. This is due to the weak pinning strength described above.

### SUMMARY OF THE INVENTION

The present invention has been made so as to solve such problems and to provide an oxide superconducting material to be applied at a higher temperature and a higher magnetic field, and a method for producing the same.

The oxide superconducting material of the present invention is the one represented by the following general formula (1):

Bi₂₋ₓPbₓ(Sr, Ca)₃Cu₂O_{q}

(0.2 ≦ x ≦ 0.6, q ≦ 8.2) (1)

and has orthorhombic and/or monoclinic structures.

The present invention further provides the method for producing the aforementioned oxide superconducting material which comprises the steps of forming a composition of Bi, Pb, Sr, Ca, and Cu mixed at an atomic ratio of Bi : Pb : Sr : Ca : Cu = 2-x : x : 2 : 1 : 2 and thermally treating the composition in an inert gas atmosphere with oxygen partial pressure of 1/13 atm or less.

According to the present invention, the pinning strength is enhanced, whereby the desired objective can be achieved.

### BRIEF DESCRIPTION OF THE DRAWING

Fig. 1 is a graph depicting the relation of Pb content (x) and oxygen content (q) in a superconducting material according to one embodiment of the present invention.

Fig. 2 is a graph depicting the relation of Pb content and magnetization hysteresis (ΔM) under various magnetic fields in a superconductive material according to one embodiment of the present invention.

### DETAILED DESCRIPTION OF THE PREFERRED EMBODIMENTS

### 〈Examples 1 - 5〉

Raw materials in powder, Bi₂O₃, PbO, SrCo₃, CaCO₃, and CuO were weighed such that the atomic ratio of the metal atoms might be Bi : Pb : Sr : Ca : Cu = 2-x : x : 2 : 1 : 2 (x = 0, 0.1, 0.2, 0,3, 0.4, 0.5, 0.6 and 0.8). x = 0.2, 0,3, 0.4, 0.5 and 0.6 for Examples 1, 2, 3, 4 and 5, respectively. x = 0.1, 0.8 and 0 for Comparative Examples 1, 2 and 4, respectively. Then, the powdery raw materials was subjected to mixing by ball milling. The mixed powder with each the foregoing composition was press molded at a pressure of 600 kgf/cm², was calcined in air at 790°C for 10 hours and was ground. The process consisting of press molding, calcination and grinding was repeated twice. The resulting eight species of the calcined powders were molded at a pressure of 1,000 kgf/cm², and sintered in nitrogen stream at 770 to 820°C for 30 hours. For comparison as to the oxygen content, a sample of Comparative Example 4 was prepared by sintering a Bi 2212 material with no Pb substitution for Bi (x = 0; Comparative Example 3) in air at 790°C for 3 hours. The structure of each of the resulting sintered products was analyzed by powder X-ray diffraction analysis. The oxygen content was determined by a coulometric titration. The critical temperature (Tc^{on}); temperature wherein a diamagnetism is initiated) was evaluated with SQUID (Superconducting Quantum Interference Device) magnetrometer, a device for measuring magnetization ratio. The results are shown in Table 1.

**Table 1**

| Composition and Properties of Samples | | | | |
|---|---|---|---|---|
| | Composition | Impuri -ties | Crystalline structure | Tc^{on}(K) |
| Example 1 | Bi_{1.8}Pb_{0.2}Sr₂CaCu₂O_{8.100} | - | orthorhombic | 83 |
| 2 | Bi_{1.7}Pb_{0.3}Sr₂CaCu₂O_{8.054} | - | orthorhombic | 82 |
| 3 | Bi_{1.6}Pb_{0.4}Sr₂CaCu₂O_{8.003} | - | orthorhombic/monoclinic | 83 |
| 4 | Bi_{1.58}Pb_{0.52}Sr₂CaCu₂O_{7.983} | - | monoclinic | 83 |
| 5 | Bi_{1.4}Pb_{0.6}Sr₂CaCu₂O_{7.931} | - | monoclinic | 83 |
| Comparative Example 1 | Bi_{1.9}Pb_{0.1}Sr₂CaCu₂O_{8.130} | - | tetragonal | 84 |
| Comparative Example 2 | Bi_{1.2}Pb_{0.8}Sr₂CaCu₂O_{7.914} | Ca₂PbO₄ | monoclinic | - |
| Comparative Example 3 | Bi₂Sr₂CaCu₂O_{8.154} | - | tetragonal | 87 |
| Comparative Example 4 | Bi₂Sr₂CaCu₂O_{8.284} | - | tetragonal | 76 |

The table shows that only Bi 2212 phase is obtained (without impurities) at x = 0.6 or less and that Tc^{on} is almost constant with no dependency on x. Comparative Example 4 shows lower Tc.

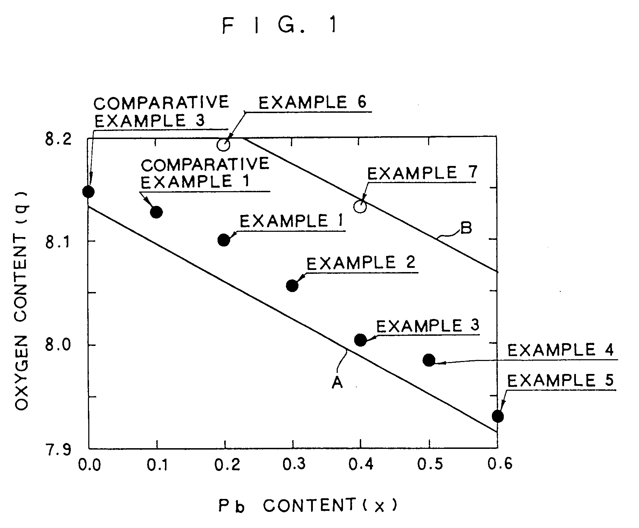

Further, Fig. 1 is a characteristic graph depicting the relation of Pb contents (x) and oxygen contents (q) in Bi₂₋ₓPbₓSr₂CaCu₂O_{q} samples (Examples 1 - 5) and the samples of Comparative Examples 1 and 3. On one hand, line A is represented by q = 8.13 - 0.38x. On the other hand, line B is represented by q = 8.29 - 0.38x. The data of Examples 1 through 5 is located in the region between the two lines A and B.

In addition, in the samples of 0.1 ≦ x ≦ 0.6 (Examples 1 - 5), the oxygen contents show a decrease in proportion to the increase in Pb content (x).

### 〈Examples 6 - 7〉

The circles O in Fig. 1 show the data of the samples obtained by sintering the materials for Examples 2 and 4 in the stream of a mixed gas (N₂-100/13 at. % O₂), i.e. in nitrogen containing oxygen at an atomic ratio of 100/13% (Examples 6 and 7, respectively).

Incidentally, in case of the sintering in N₂-100/13 at. % O₂, a sample of single phase (without impurities) was obtained provided that x ≦ 0.4. On the contrary a sample of multiple phase (with impurities) was obtained provided that Pb ≦ 0.5.

Examples 6 and 7 both are included in the region between the lines A and B.

Next, for comparing the characteristics of critical current density (Jc) in the samples of Examples 1 - 5, magnetization curve was measured under a magnetic field of 1, 2, 3, 4 and 5 T with a SQUID device.

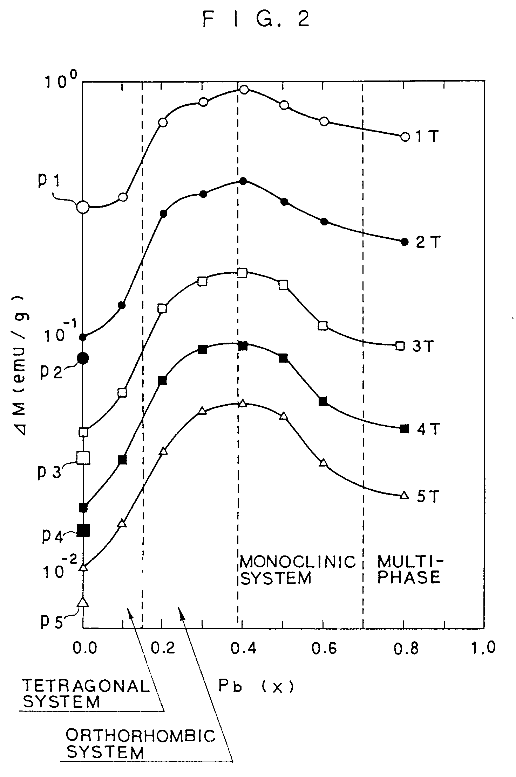

Fig. 2 is a characteristic chart wherein the magnetization hysteresis ΔM's at 20 K are plotted to the Pb substitution amount x for the samples of Examples 1 - 5 and Comparative Examples 1 - 3.

In the figure, Curves 1T, 2T, 3T, 4T and 5T represent each magnetization characteristics of Examples 1 - 5 and Comparative Examples 1 - 3 under magnetic fields of 1T, 2T, 3T, 4T and 5T, respectively. The points P1, P2, P3, P4 and P5 represent the magnetization characteristics for Comparative Example 4 under magnetic fields of 1T, 2T, 3T, 4T and 5T, respectively. With observation by an scanning electron microscope (SEM) and the like, no difference was recognized in the size of crystalline particles and orientation in the crystalline axis for each sample. Therefore, ΔM is considered to be proportional to the "average value" of Jc flowing inside the crystalline particles. Thus, the increase in ΔM with increase of Pb substitution amount x at 0 ≦ x ≦ 0.4 corresponds to the improvement of Jc.

As far as concerned is the two samples with no Pb substitution (Comparative Examples 3 and 4) under the same magnetic field, Comparative Example 4 sintered in the air has a greater ΔM at lower magnetic fields while Comparative Example sintered in nitrogen has a greater ΔM at higher magnetic fields. This seems to reflect that Example 4 has higher carrier density and Example 3 has higher Tc with higher Bc₂. However, no difference can be recognized for the pinning properties between Comparative Examples 3 and 4, considering the smallness of difference in ΔM.

In the figure, under the entire magnetic fields of 1T to 5T, ΔM increases until the Pb substitution amount x increases in the range of 0 ≦ x ≦ 0.4. ΔM reaches its peak at x = 0.4. The extent of the ΔM improvement (i.e. Jc improvement) by Pb substitution is more remarkable at a higher magnetic field. Furthermore, this effect is distinctive in a range of 0.2 ≦ x ≦ 0.6 at every magnetic field. The ΔM increase in the range of 0.2 ≦ x ≦ 0.6 for Examples 1 - 5 are two times or more as much as that of the case of no Pb substitution (Comparative Examples 3 and 4).

The Jc of a superconductor in a high magnetic field is in proportion to the pinning strength for the quantized magnetic flux, which is caused by the inhomogeneity existing inside the superconductor. As to the Jc improvement by Pb substitution, the effect of this Jc improvement reaches the maximum around x = 0.4. As shown in Table 1, the composition at x = 0.4 is close to the orthorhombic-to-monoclinic structural transformation. Thus, the maximum distortion point of crystalline field around x = 0.4 changes to the pinning center presumably improving Jc.

In accordance with another aspect of the present invention, sintering the superconductive material of the present invention in an inert gas containing oxygen at a ratio of 100/13 at. % or less, not only regulates their oxygen content but also influences the maximum of their Pb substitution amount to bring about 2212 phase alone. When Pb is substituted for Bi, it is very difficult to obtain only Bi 2212 phase with sintering in the air. However, the thermal treatment (sintering) in an atmosphere of N₂-100/13 at. % O₂ makes it possible to form 2212 phase alone. The improvement of Jc properties via Pb substitution was also observed same as that with sintering in N₂ only.

As has been described above, the thermal treatment in an inert gas atmosphere is indispensable for synthesizing a pure 2212 phase with a higher Jc property.

According to the present invention, the pinning strength of Bi 2212 phase could be enhanced, and hence, the critical current density and its dependency thereof on temperature and magnetic field could be improved distinctively. It is thereby possible that conventional superconducting magnets designed to generate a magnetic field of e.g. 3.5 T at 20 K can be reconstructed to generate a magnetic field of about 5 T although they are of the same size. And furthermore, it is also possible that a superconducting magnet of the same size as that of conventionally designed superconducting magnet to generate a magnetic field of 5 T and 15 K generates a magnetic field of 5 T at 20 K.

In accordance with the present invention, as has been explained above, there is provided a superconducting material which can be used at a higher temperature and at a higher magnetic field.

According to the present invention, there is provided an oxide superconducting material

Bi₂₋ₓPbₓ(Sr, Ca)₃Cu₂O_{q} (0.2 ≦ x ≦ 0.6, q ≦ 8.2) (1)

having orthorhombic and/or monoclinic structures. The present invention also provides a method for producing the above oxide superconducting material comprising the steps of forming a composition of Bi, Pb, Sr, Ca and Cu mixed at an atomic ratio of Bi : Pb : Sr : Ca : Cu = 2-x : x : 2 : 1 : 2, and thermally treating the composition in an inert gas atmosphere with oxygen partial pressure of 1/13 atm or less.

The oxide superconducting material of the present invention is applicable at a higher temperature and at a higher magnetic field.

## Claims

1. An oxide superconducting material represented by the following general formula (1):
Bi₂₋ₓPbₓ(Sr, Ca)₃Cu₂O_{q} (0.2 ≦ x ≦ 0.6, q ≦ 8.2) (1)
and having orthorhombic and/or monoclinic structures.

2. The oxide superconducting material according to claim 1, wherein 8.29 - 0.38x ≧ q ≧ 8.13 - 0.38x.

3. A method for producing an oxide superconducting material Bi₂₋ₓPbₓ(Sr, Ca)₃Cu₂O_{q} (0.2 ≦ x ≦ 0.6, q ≦ 8.2) comprising the steps of forming a composition of Bi, Pb, Sr, Ca, and Cu mixed at an atomic ratio of Bi : Pb : Sr : Ca : Cu = 2-x : x : 2 : 1 : 2; and thermally treating the composition in an inert gas atmosphere with oxygen partial pressure of 1/13 atm or less.

4. The method according to claim 3, wherein the step of thermally treating the composition includes sintering the composition at 750 to 830°C for one hour or more.
